# EUROPÄISCHE PATENTANMELDUNG

(11) **EP 0 707 442 A2**
(43) Veröffentlichungstag der Anmeldung: **17.04.1996**
(21) Anmeldenummer: 95114654.7
(22) Anmeldetag: 18.09.1995
(51) Int. Cl.: H05K 9/00

(54) **Nachrichtenleitungsfilter**

(30) Priorität: 19.09.1994 DE 9415164 U
(71) Anmelder: SIEMENS MATSUSHITA COMPONENTS GmbH & CO KG, D-81617 München (DE)
(72) Erfinder: Flämig, Gerd, D-89518 Heidenheim (DE); Schmittmann, Helmut, D-89537 Giengen (DE)
(74) Vertreter: Fuchs, Franz-Josef, Dr.-Ing.

(57) **Zusammenfassung**

Bei einem Nachrichtenleitungsfilter für mindestens vier, insbesondere zehn, Doppeladern, das in ein geschirmtes Dreikammergehäuse eingebaut ist, sind an den beiden Endkammern Anschlußkonfigurationen (1) angeordnet. Die mittlere Kammer ist HF-dicht verlötet oder verschweißt.

## Beschreibung

Die Erfindung betrifft ein Nachrichtenleitungsfilter für mindestens vier, insbesondere zehn, Doppeladern, das in ein geschirmtes Dreikammergehäuse eingebaut ist und bei dem an den beiden Endkammern Anschlußkonfigurationen angeordnet sind.

Nachrichtenleitungsfilter für zwei Doppeladern sind bekannt und beispielsweise im Siemens-Datenbuch 1980/81 "Funk-Entstörfilter", S.154-157 beschrieben. Das bekannte Filter ist in einem Gehäuse untergebracht, das einen verschraubbaren Deckel besitzt, so daß Anschlüsse vom Anwender selbst angebracht bzw. ausgetauscht werden können. Diese Einbauweise führt allerdings zu Schwierigkeiten hinsichtlich der erforderlichen Dämpfung, da bei nicht ordnungsgemäßem Verschluß die geforderte Schirmung nicht mehr gewährleistet ist. Weiterhin besitzt das bekannte Filter nur zwei Doppeladern, so daß eine größere Anzahl von Einzelfiltern benötigt wird, wenn mehr als zwei Doppeladern in den geschirmten Raum eingeführt werden sollen.

Aufgabe der vorliegenden Erfindung ist es, ein Nachrichtenleitungsfilter für mindestens vier, bevorzugt zehn, Doppeladern anzugeben, bei dem die vorstehend geschilderten Schwierigkeiten behoben sind.

Diese Aufgabe wird erfindungsgemäß dadurch gelöst, daß die mittlere Kammer HF-dicht verlötet oder verschweißt ist.

Dadurch ergibt sich der Vorteil, daß Probleme vermieden werden, die bei verschraubten Schirmgehäusen hinsichtlich der Abschirmung auftreten können. Weiterhin wird die Packungsdichte erhöht, was sowohl die Fertigungskosten reduziert als auch den Montageaufwand beim Filterzusammenbau bzw. beim Einbau in Filterschränke vermindert. Außerdem ist beim Einsatz von Einzelfiltern ein entsprechend größerer Einbauraum nötig.

Weitere Vorteile ergeben sich, wenn nach bevorzugten Ausführungsbeispielen unterschiedliche Anschlußkonfigurationen zum Einsatz kommen, wie z.B.Schneid/Klemm-Verbinder (LSA-Plus Technik), Lötleisten, Schraub/Klemm-Verbinder und/oder Schraubklemmen. Hierdurch ist die Kontaktierung der Leitungen in verschiedenen Arten beim Anwender möglich.

Die Erfindung wird im folgenden anhand von Ausführungsbeispielen erläutert.

In der dazugehörenden Zeichnung zeigen:
Fig.1 die Ansicht der Eingangsseite eines Nachrichtenleitungsfilters mit Schneid/Klemmverbindern,
Fig.2 eine Seitenansicht der Fig.1,
Fig.3 eine Seitenansicht eines Filters mit EMP-Schutz,
Fig.4 die Ansicht der Eingangsseite des Filters nach Fig.3,
Fig.5 die Eingangsseite eines Filters mit Lötleiste und
Fig.6 die Eingangsseite eines Filters mit Schraubklemmen.

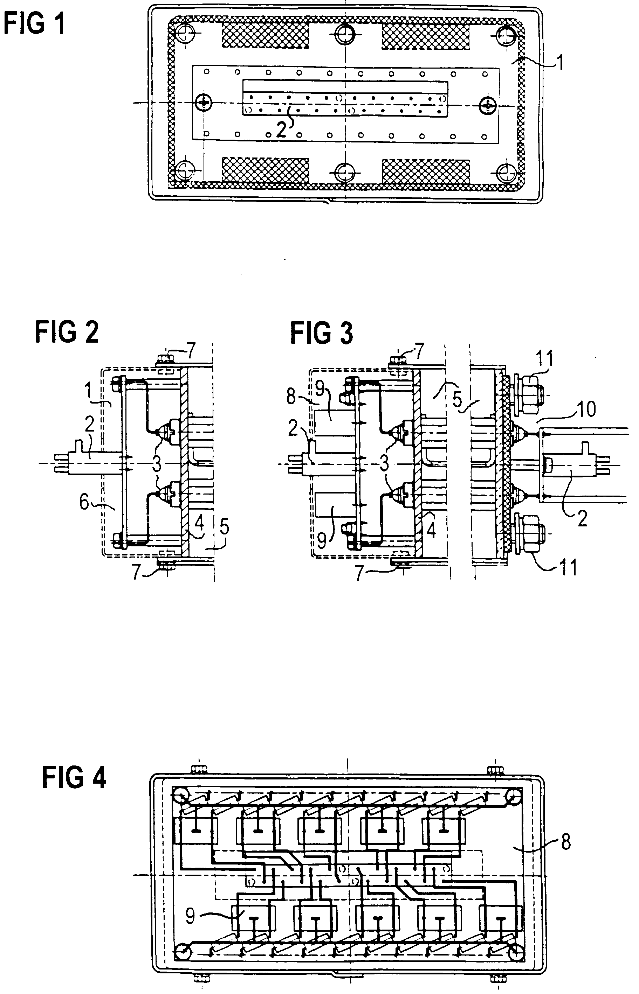

In der Fig.1 ist die eingangsseitige Anschlußkonfiguration 1 eines Nachrichtenleitungsfilter mit zehn Doppeladern (DA) dargestellt. Die Anschlüsse werden durch Schneid/Klemmverbinder 2 gebildet (LSA-Plus-Technik).

Fig.2 zeigt die Seitenansicht des Nachrichtenleitungsfilters nach Fig.1., wobei eine DA sichtbar ist. Durchführungselemente 3 sind in der Wand 4 der mittleren Kammer angeordnet. Die mittlere Kammer 5 ist nicht näher dargestellt, da sie die bekannten Filterkombinationen für Nachrichtenleitungsfilter enthält. Die mittlere Kammer 5 ist HF-dicht durch Lötung oder Schweißung verschlossen, während die eingangsseitige Kammer 6 beispielsweise aufgesteckt oderdurch Schrauben 7 befestigt ist. Wahlweise können auch andere Anschlußkonfigurationen eingesetzt werden (LSA-Plus Technik, Löttechnik, Schraub-Klemmtechnik). Die Ausgangsseite des Nachrichtenleitungsfilters weist dieselbe Anschlußkonfiguration 1 wie die Eingangsseite auf, kann aber auch anders bestückt werden.

Die Fig.3 zeigt eine Anschlußkonfiguration 8 mit Schneid/Klemmverbindern 2, die eingangsseitig einen EMP-Schutz besitzt, der durch die Überspannungsableiter 9 gebildet wird. Im übrigen entspricht die Anschlußkonfiguration 8 in ihrem Aufbau derjenigen, die in Fig.2 dargestellt ist. Die ausgangsseitige Anschlußkonfiguration 10 besitzt denselben Aufbau wie die Anschlußkonfiguration 1 nach Fig.2. Mit Hilfe der Schrauben 11 wird die Filtereinheit unter Verwendung einer geeigneten vorkonfektionierten, leitfähigen HF-Dichtung (z.B. Metallgestrick) in die Schirmwand eingeschraubt.

In Fig.4 ist die Ansicht der Anschlußkonfiguration 8 nach Fig.3 mit den Überspannungsableitern 9 dargestellt.

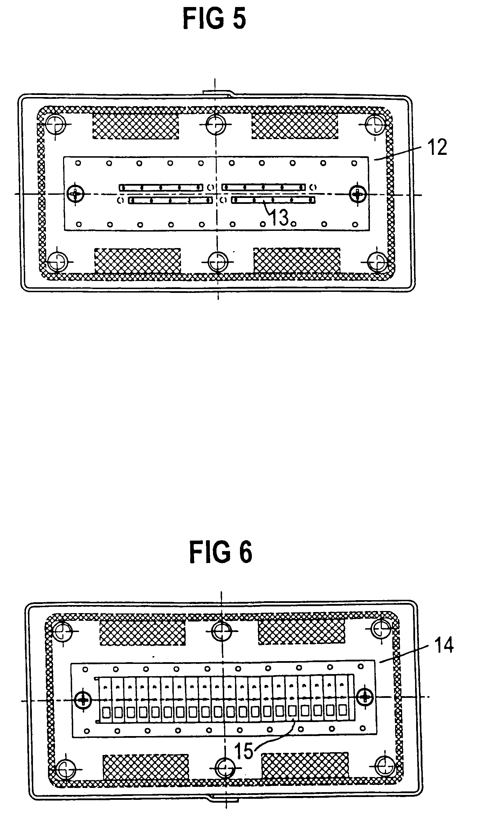

Fig.5 zeigt eine Anschlußkonfiguration 12 mit Lötleisten 13, während in Fig.6 eine Anschlußkonfiguration 14 mit Schraubklemmen 15 dargestellt ist.

Wenn es gewünscht ist, können die gezeigten Anschlußkonfigurationen auch miteinander kombiniert werden so daß eingangs- und ausgangsseitig unterschiedliche Anschlußkonfiguration, gegebenenfalls mit EMP-Schutz, möglich sind.

Insgesamt gesehen zeichnet sich das Nachrichtenleitungsfilter nach der Erfindung dadurch aus, daß es eine kompakte, kostengünstige Bauweise besitz, daß es bei der Montage einfach einzubauen und gut zugänglich ist, daß es mittels Einschubtechnik in Gehäuse eingebaut werden kann, daß die HF-Dichtheit des Filters verbessert ist, da das Gehäuse mit dem Einbau dicht, z.B. durch Löten, verbunden werden kann, und daß die Kontaktierung der Leitungen beim Anwender in verschiedenen Arten (LSA-Plus-Technik, Löttechnik, Schraub-Klemm-Technik) möglich ist, wobei die unterschiedlichen Kontaktierarten wahlweise auch mit EMP-Schutz (Eingangsseite) ausgerüstet werden können.

## Patentansprüche

1. Nachrichtenleitungsfilter für mindestens vier, insbesondere zehn, Doppeladern, das in ein geschirmtes Dreikammergehäuse eingebaut ist und bei dem an den beiden Endkammern Anschlußkonfigurationen angeordnet sind,
**dadurch gekennzeichnet,**
daß die mittlere Kammer (5) HF-dicht verlötet oder verschweißt ist.

2. Nachrichtenleitungsfilter nach Anspruch 1,
**dadurch gekennzeichnet,**
daß unterschiedliche Anschlußkonfigurationen (1,12,14) einsetzbar sind.

3. Nachrichtenleitungsfilter nach Anspruch 1 oder 2,
**dadurch gekennzeichnet,**
daß als Anschlußkonfiguration (1) Schneid/Klemm-Verbinder (2) (LSA-Plus Technik), Lötleisten (13), Schraub/Klemm-Verbinder und/oder Schraubklemmen (15) verwendet sind.

4. Nachrichtenleitungsfilter nach einem der Ansprüche 1 bis 3,
**dadurch gekennzeichnet,**
daß die Anschlußkonfigurationen (8) der Eingangsseite einen EMP-Schutz (9) besitzen.
